Europäisches Patentamt

European Patent Office

Office européen des brevets

(11) Publication number: **0 090 099**

**B1**

(12) **EUROPEAN PATENT SPECIFICATION**

(45) Date of publication of patent specification: **26.04.89**

(21) Application number: **82201536.8**

(22) Date of filing: **03.12.82**

(51) Int. Cl.⁴: **H 01 L 27/02,** H 01 L 27/06, H 03 K 19/092

(54) Integrated logic circuit having an interface transistor.

(30) Priority: **29.03.82 US 362923**

(43) Date of publication of application:
**05.10.83 Bulletin 83/40**

(45) Publication of the grant of the patent:
**26.04.89 Bulletin 89/17**

(84) Designated Contracting States:
**DE FR GB IT NL**

(56) References cited:
**EP-A-0 023 118**

**IEEE JOURNAL OF SOLID-STATE CIRCUITS,
vol. SC-14, no. 3, June 1979, pages 585-590,
IEEE, New York, US; J. LOHSTROH: "ISL, A fast
and dense low-power logic, made in a standard
Schottky process"**

**ELECTRONIC DESIGN'S TELECOM DESIGN
1980, A Conference for Telecommunication
Systems Designers", April 1981, pages 5-20;
G.R. DAVIS: "High performance ISL gate array"**

**SEMICONDUCTOR DEVICE COURSE, Heverlee,
1st-4th June 1976, pages 1-15, Katholieke
Universiteit, Leuven, BE; A. SLOB: "The design
with I2L"**

(73) Proprietor: **N.V. Philips' Gloeilampenfabrieken
Groenewoudseweg 1
NL-5621 BA Eindhoven (NL)**

(72) Inventor: **Bellavance, Joseph Thomas
c/o INT. OCTROOIBUREAU B.V. Prof. Holstlaan 6·
NL-5656 AA Eindhoven (NL)**

(74) Representative: **Veerman, Jan Willem et al
INTERNATIONAAL OCTROOIBUREAU B.V. Prof.
Holstlaan 6
NL-5656 AA Eindhoven (NL)**

(56) References cited:
**RADIO FERNSEHEN ELEKTRONIK, vol. 28, no.
9, September 1979, pages 560-563; G.
TURINSKY: "Digitale Pegelwandler für LSI-
Schaltkreise"**

Courier Press, Leamington Spa, England.

# Description

The invention relates to an integrated logic circuit having a signal input formed by a control electrode of a transistor and having one or more outputs each coupled *via* a diode to a first main electrode of the transistor, the signal input comprising current supply means, the intergrated circuit comprising a semiconductor body having a major surface and plural surface regions of a first conductivity type adjoining said major surface, said plural surface regions being situated on a common substrate region of a second conductivity type opposite to the first conductivity type, each of said surface regions being surrounded at the major surface by an insolation zone by means of which the surface regions are isolated electrically from each other at least during operation, a first of said surface regions of the first conductivity type serving as the first main electrode of the transistor, said control electrode of the transistor being a surface zone of the second conductivity type situated in said first surface region and a second main electrode of the transistor adjoining the major surface and being separated from the control electrode by a rectifying junction, the first surface region at the major surface adjoining one or more conductive tracks each forming with the first main electrode a rectifying junction which serves as the said diode, and in which in the first surface region and spaced from the said surface zone of the second conductivity type a further surface zone of the second conductivity type is present.

Such integrated logic circuit is known from German Patent Application P 30 13471.5. Particularly the example described with reference to Figures 7 and 8 of this German Patent Application shows a static induction transistor which is merged with an MOS current source transistor. The control electrode of the static induction transistor simultaneously forms the drain region of the current source transistor. Spaced therefrom is the further surface zone which forms the source region of the current source transistor. The source and drain regions define a channel region therebetween which channel region extends below an insulated gate electrode which is provided at the major surface of the semiconductor body.

Other examples of integrated logic circuits having current source means connected to the control electrode of an inverter transistor, which control electrode forms the signal input and the signal outputs each being coupled *via* a diode to the first main electrode of the inverter transistors are Schottky Transistor Logic (STL) and Integrated Schottky Logic (ISL).

Schottky Transistor Logic is described in, for example, IEEE ISSCC, Febr. 1975, Digest of Technical Papers, pp. 173—173.

Integrated Schottky Logic (ISL) is a relatively new form of logic useful in large scale integrated circuits. ISL was first described in IEEE Journal of Solid State Circuits, Volume SC-14, No. 3, June 1979 in a paper authored by Jan Lohstroh, entitled, "ISL, a Fast and Dense Lower Power Logic, Made in a Standard Schottky Process". ISL provides a good compromise between low power Schottky TTL (LSTTL) and integrated injection logic ($I^2L$). It satisfies a demand for a circuit that consumes less power and takes up less chip area than LSTTL and reguires a faster speed than $I^2L$.

An ISL gate in its simplest form comprises a current source, a normally operated collector down NPN transistor with a merged PNP clamp, and one or more output Schottky diodes. The PNP clamp, which may consist of the combination of lateral PNP and a vertical PNP transistor sharing the collector and base regions of the NPN transistor, operates to prevent the NPN transistor from going too deeply into saturation, thereby reducing the saturation delay.

The integrated logic circuits of the kind described have a relatively small logic voltage swing and correspondingly low signal voltage level. Furthermore these logic circuits usually are operated at low current levels. In connection herewith it often is desirable to translate these signal levels to particularly, the more commonly used TTL signal levels.

The present invention has for one of its objects to provide a compact integrated circuit arranged within a single island region, that will translate from the relatively low signal level to a substantially larger signal level without too much loading of the inverter transistor.

Although the IEEE article referred to above states that it is possible to combine ISL with other forms of logic, such as ECL, $I^2L$, and TTL on the same chip, it does not describe any way of translating between ISL and TTL. The obvious way to translate between an ISL gate and a TTL gate is to simply add two additional ISL gates between the input ISL gate and the TTL gate. However, the two additional ISL gates, each in its own isolated island, occupies too much space and undesirably introduces additional time delay.

Interface circuits are well known for other forms of logic. In Japanese Kokai No. 53-57723, an $I^2L$ to TTL interface circuit uses a PNP transistor coupled to the output of the collector up NPN $I^2L$ transistor.

European Patent Application 0009083 discloses a CML to TTL interface circuit, and German Patent Application 3.024.273 discloses an ECL to TTL interface circuit.

According to the invention an integrated logic circuit of the kind described in the preamble is characterized in that said further surface zone serves as an extra signal output of the logic circuit and forms the emitter of a further transistor, the base and collector of said further transistor being formed by the first surface region and the common substrate region, respectively.

This integrated logic circuit has a compact structure with an extra output transistor integrated in a single common island region and providing an emitter follower output which effectively translate to larger signal levels and simultaneously permits the logic gate to perform normal logic operation such that other outputs of usual structure can be connected to adjacent logic gate circuits of an integrated logic network.

In a preferred form of the integrated logic circuit according to the invention, the transistor is an ISL and clamped NPN transistor and the further transistor is a PNP translation transistor.

Preferably the PNP translation transistor is coupled to a TTL inverter circuit which is present in one or more separate isolated islands of the integrated circuit.

One of the conventional outputs of the logic gate circuits may be used to provide an active pulldown function for one of the output transistors of the TTL inverter circuit. The advantages of this active pulldown function are a reduction in the number of components, increased speed, and higher output breakdown voltage. These advantages will be discussed more fully in the specific description of the preferred embodiments.

Brief description of the drawings

Figure 1 is a diagrammatic plan view of a part of an integrated circuit layout showing the ISL to TTL translator according to the invention.

Figure 2 is a sectional view taken along line 2—2 of Figure 1.

Figure 3 is an equivalent circuit representation of the ISL to TTL translator of Figures 1 and 2.

Figure 4 is a logic diagram showing translation between ISL and TTL circuitry without using the present invention.

Figure 5 is a logic diagram showing translation between ISL and TTL circuitry according to the invention.

Figure 6 is a schematic circuit representation of the logic diagram of Figure 5.

Figure 7 is a schematic circuit showing a modification of Figure 6 in which an ISL Schottky diode is used as an active pulldown for one of the output TTL transistors.

Description of the preferred embodiments

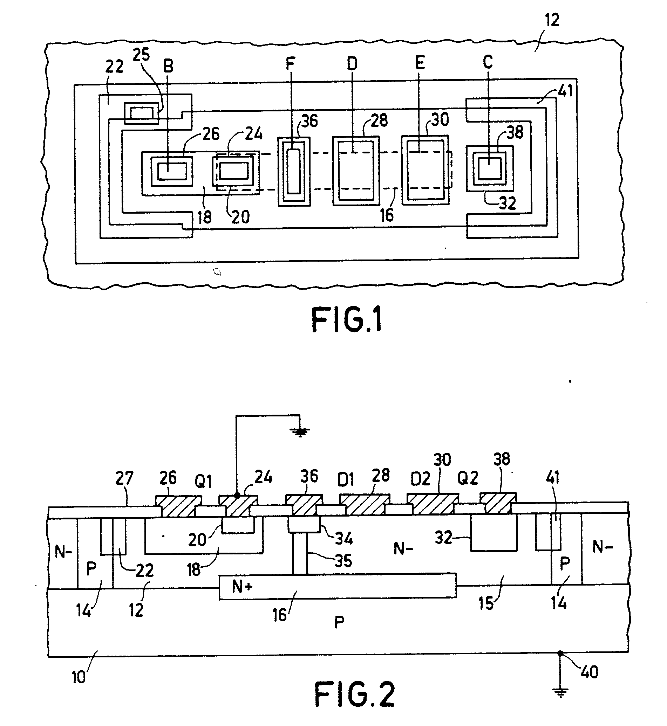

Reference is now made to Figures 1 and 2 which show a greatly enlarged portion of an integrated circuit incorporating the translator according to the invention. This example is an ISL to TTL translator. A p-type substrate region 10, such as silicon, is provided with an n-type epitaxial layer 12. A peripheral isolation means 14 laterally surrounds a separate portion of the epitaxial layer 12 and extends in depth to the substrate region 10. Within the confines of the isolation means 14 there is formed a single isolated island or tub 15 that contains the ISL to TTL translation circuit. The isolation means 14 may be produced by forming a p-type diffusion within the epitaxial layer 12, thereby surrounding the isolated island 15 with a pn semiconductor junction. Alternatively, the isolation means 14 may be constituted wholly or partly by a dielectric material such as silicon dioxide that is formed by local oxidation of the n-type silicon epitaxial layer 12, which is the process known by the acronym LOCOS. Other dielectric material such as silicon nitride, may also be used for the isolation means 14.

A heavily doped n-type buried layer 16 is provided at the interface of the substrate region 10 and epitaxial layer 12 where the pn junction is formed. The buried layer 16 stops considerably short of the isolation means 14 on all four sides thereof, and extends in depth partly into the epitaxial layer 12 and partly into the substrate region 10. The buried layer 16 may be produced by conventional processing means, as by implanting an n-type dopant into the substrate region 10 prior to epitaxial deposition of the layer 14, after which, during formation of the epitaxial layer 14, the n-type dopant will diffuse vertically upward into the epitaxial layer 12 and vertically downward into the substrate region 10.

An NPN ISL transistor Q1 is provided at one extreme end of the isloated island 15 and a PNP translation transistor Q2 is provided at the other end of the isolated island 15. The ISL transistor Q1 is formed by a p-type base region 18 formed in the epitaxial layer 12, which functions as the collector, and a heavily doped n-type emitter region 20 formed in the base region 18.

In a structure wherein the isolation region 14 is produced by a p-type region to form PN junction isolation, preferably a p-type region 22 surrounds the base region 18 on three sides thereof in the form of a U-shaped collar. The p-type peripheral or collar region 22 is spaced close to the base region 18 and merges with the isolation region 14. The emitter region 20 is offset from the center of the base region 18 in a direction away from the p-type collar region 22. Metallic ohmic contacts 24, 25, and 26 extending through openings in a silicon dioxide layer 27 are provided on the surfaces of the emitter region 20, collar region 22, and base region 18, respectively.

The buried layer 16 lies under the emitter region 20 but does not underlie the portion of the base region 18 that is free of the emitter region 20. The end of the buried layer 16 lies approximately beneath the center of the base region 18, so that the part of the epitaxial collector region 12 and the part of the substrate region 10 underlying the p-type collar region 22 and also underlying approximately one half of the base region 18 are free of the buried layer 16.

While the NPN transistor Q1 has emitter, base, and collector regions 20, 18, and 12 respectively, it is shunted by a two part PNP clamping transistor having a vertical part and a lateral part. The vertical part of the PNP clamping transistor has region 18 as the emitter, epitaxial region 12 as the base, and the substrate region 10 as the collector. The lateral part of the PNP clamping transistor has the region 18 as the emitter, epitaxial region 12 as the base, and the p-type collar region 22 as the collector. The p-type collar region 22 enhances the effect of the parasitic lateral PNP transistor already present in a junction isolated structure by decreasing the base width, thereby increasing the beta with attendant increase in switching speed of the ISL transistor Q1.

The two part PNP clamping transistor limits the extent to which the NPN transistor Q1 goes into deep saturation and thereby reduces the saturation delay. A more detailed discussion of this effect and the advantages of the ISL logic form is found is the Lohstroh paper referred to above.

In a structure wherein the isolation region 14 comprises a dielectric material, the p-type collar region 22 is omitted. In that case, the PNP clamping transistor comprises only the vertical part, and there is no lateral part present. Alternatively, with dielectric isolation, clamping action for the NPN transistor Q1 may be provided by a merged inversely operated NPN clamping transistor. Such a structure is described in the Lohstroh article referred to above. Accordingly, the term "ISL clamped NPN transistor" is intended to be generic to all of the aforementioned ways of clamping the NPN transistor Q1, whether they incorporate dielectric isolation or junction isolation, and whether they employ a single clamp or dual clamp of the PNP type or NPN type.

The remainder of the ISL structure comprises one or more Schottky junction diodes D1 and D2 formed in the collector region of the ISL transistor Q1, which in this case, is the epitaxial layer 12. The Schottky diodes D1 and D2 lie centrally within the isolated island 15 directly above the buried layer 16. The Schottky diodes are constituted by two metallic contacts 28 and 30 provided on the surface of the epitaxial layer 12 and are each made of such metal as to form a Schottky barrier junction with the n-type epitaxial material. A suitable metal for the Schottky contacts is a platinum-nickel alloy containing 60% platinum and 40% nickel, with a Schottky barrier height of about 0.78 eV.

At the opposite end of the isolated island 15 from the ISL transistor Q1 there is located the PNP translation transistor Q2. The emitter of the PNP transistor Q2 is constituted by a p-type region 32 formed in the epitaxial layer 12 over a region of the epitaxial layer-to-substrate junction that is free of the buried layer 16. The base of the PNP transistor Q2 is constituted by the epitaxial layer 12. To provide a base contact region for the PNP transistor Q2 and a collector contact region for the NPN transistor Q1, a heavily doped n-type region 34 is formed in the epitaxial layer 12 directly over the buried layer 16. A heavily doped n-type plug 35 connects the contact region 34 with the buried layer 16 through a low resistance path. The collector of the PNP transistor Q2 is formed by the substrate region 12. Thus, the PNP transistor Q2 is vertically arranged within the isolated island 15. An ohmic metallic contact 36 is provided on the surface of the base contact region 34, and another ohmic metallic contact 38 is provided on the surface of the emitter region 32. The substrate region 10 has a connection at 40 for connecting a reference voltage such as ground.

In a structure having junction isolation, the p-type emitter region 32 may be surrounded on three sides thereof by a p-type peripheral or collar region 41 to enhance the lateral PNP transistor action that appears in shunt with the PNP translation transistor Q2. The lateral transistor has the p-type region 32 as emitter, the epitaxial layer 12 as base, and the isolation region 14 as collector. The p-type collar region 41 will narrow the base width of the lateral transistor, thereby increasing the beta with attendant increase in switching speed of the translation transistor Q2.

The impurity doping concentration for an exemplary structure are such as to provide the following resistivities: two ohm-centimeters for the substrate region 10, 0.3 ohm-centimeter for the epitaxial layer 12, 200 ohms per square for the base diffusion (regions 18, 32, 22, 41), and two ohms per square for the emitter and N+ diffusion (regions 20, 34, 35).

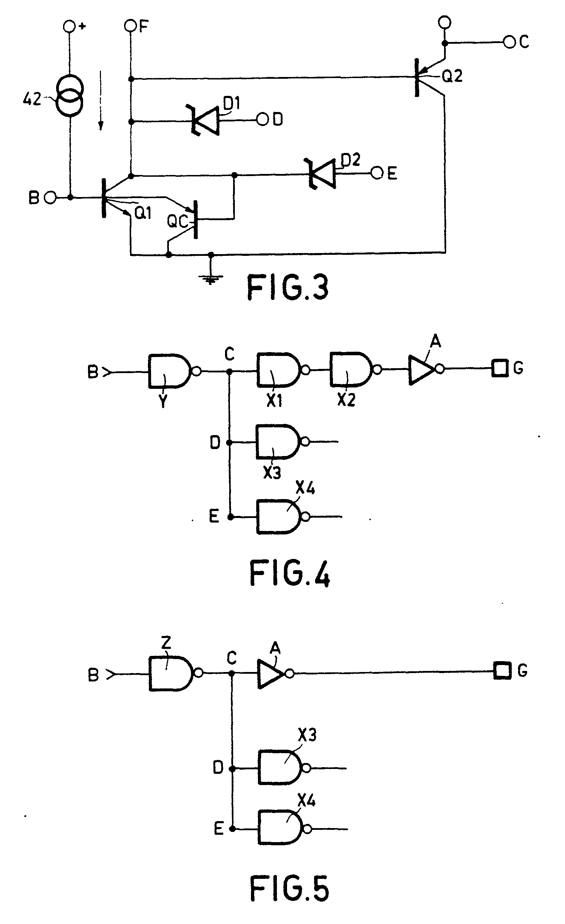

An equivalent circuit diagram of the ISL to TTL translator structure is shown in Figure 3. In Figure 3, the ISL transistor Q1 is shown to consist of an NPN transistor having a PNP clamping transistor QC sharing common electrodes therewith, the PNP clamping transistor QC having both the lateral and the vertical components, or only a single component, as discussed above. An input terminal B is shown connected to the base of transistor Q1. Also shown connected to the base of transistor Q1 is a current source 42, which may be either a PNP transistor or a resistor coupled to a positive voltage supply. The current source 42 can be located in a separate isolated island.

A terminal F is shown at the collector of transistor Q1. The collector is coupled through the two Schottky diodes D1 and D2 to output terminals D and E respectively, and is coupled directly to the input base of the PNP translation transistor Q2. The emitter of the PNP transistor Q2 has an output at a terminal C.

A logic diagram of a circuit incorporating ISL input and TTL output is shown in Figure 4. An input at terminal B is fed to a conventional ISL gate Y having three outputs at terminals C, D, and E. A signal at output terminal D is fed to an ISL gate X3 and a signal at output terminal E is fed to an ISL gate X4. At output terminal C it is desired to translate to a TTL output terminal G. Accordingly, it is necessary to provide two more ISL gates X1 and X2 before the signal can be applied to a TTL inverter A and obtain an output at terminal G. If gate Y is to perform a logic function at the same time that the output buffer A is being driven, then gates X1 and X2 are necessary as buffers to avoid overloading gate Y.

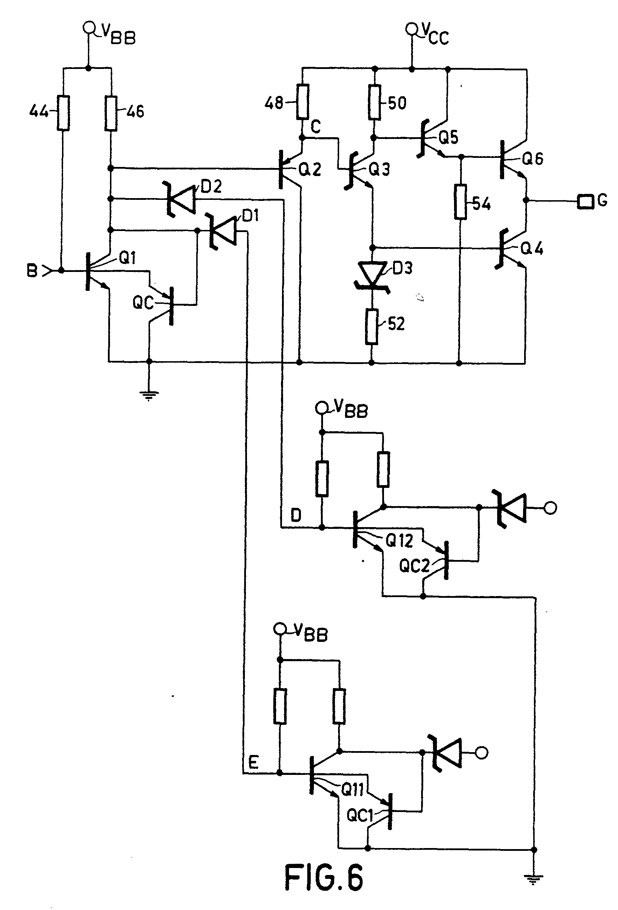

The two ISL gates X1 and X2 shown in Figure 4 can be eliminated by incorporating within the ISL gate Y the PNP translation transistor Q2 of Figures 1 through 3. The translation transistor Q2 provides the same buffering effect as the two gates X1 and X2. This improved circuit is illustrated in Figure 5 where the ISL gate Y of Figure 3 is replaced by ISL gate Z which incorporates the PNP translation transistor Q2. The ISL gate output at terminal C is applied directly to the TTL gate A without any intervening gates.

Referring now to Figure 6, there is shown a detailed schematic diagram of the improved logic shown in Figure 5. An input signal at terminal B is coupled to the base input of the ISL gate comprising transistor Q1 shunted by the PNP clamping transistor QC. A current source includes a resistor 44 connected between the base of the transistor Q1 and a source of positive DC potential $V_{BB}$, such as 1.50 volts, and preferably a resistor 46 connected between the collector of transistor Q1 and the $V_{BB}$ supply. The emitter of transistor Q1 and the collector of the clamping transistor QC are returned to common reference potential, or ground. A Schottky output diode D1 has its cathode connected to the collector of the transistor Q1 and its anode coupled to the input of another ISL gate similar to the first one and comprising NPN transistor Q11 and PNP clamping transistor QC1. Similarly, the second output diode D2 is coupled to a third ISL gate comprising NPN transistor Q12 and PNP clamping transistor QC2.

The collector of the NPN transistor Q1 is coupled to the base of the PNP translation transistor Q2. The emitter of transistor Q2 is connected through a resistor 48 to a positive supply $V_{CC}$, such as 5 volts, and is also connected to the base of a Schottky clamped NPN input transistor Q3. The collector is returned to ground. The collector of the transistor Q3 is coupled through a resistor 50 to positive supply $V_{CC}$ and to the base of a Schottky clamped transistor Q5. The emitter of transistor Q3 is connected to the anode of a Schottky diode D3 and to the base of a Schottky clamped NPN output transistor Q4. A resistor 52 is connected between the cathode of the diode D3 and ground.

The emitter of transitor Q5 is connected through a resistor 54 to ground and is also connected to the base of an NPN transistor Q6. The collectors of transistors Q5 and Q6 are connected to positive supply $V_{CC}$. The emitter of transistor Q6 and the collector of transistor Q4 are connected together to an output terminal G. The emitter of output transistor Q4 is connected to ground.

In the operation of the circuit of Figure 6, a HIGH logic input signal at terminal B will produce a LOW logic signal on the collector of transistor Q1. The LOW signal on the cathodes of diodes D1 and D2 cause the latter to conduct a LOW signal to the two ISL gates comprising transistors Q11 and Q12 respectively. The same LOW logic signal on the collector of transistor Q1 is coupled to translation transistor Q2, which is an emitter follower and conducts the LOW logic signal to its emitter at terminal C. The TTL circuit comprising transistors Q3, Q4, Q5, and Q6 functions as an inverter so that when a LOW signal is applied to the base of input transistor Q3, transistor Q3 turns OFF, transistor Q4 turns OFF, transistor Q5 turns ON, transistor Q6 turns ON, and the signal at output terminal G is HIGH.

Conversely, when a LOW logic signal is applied to the input terminal B of the ISL gate, transistor Q1 turns OFF, placing a HIGH signal on the base of transistor Q2. Transistor Q2 goes OFF and terminal C goes HIGH. A HIGH signal on the base of TTL input transistor Q3 causes the latter to turn on, causing transistor Q4 to turn ON and transistor Q5 to turn OFF, and transistor Q6 to turn off, causing the signal on output terminal G to go LOW. The HIGH signal at terminal C is clamped to the sum of the emitter-base voltages of the conductive transistors Q3 and Q4, which is low enough to keep transistor Q2 in the OFF-condition. The series connection of the emitter-base diodes of the input transistor Q3 and the output transistor Q4 is connected in parallel to the emitter-collector current path of the further transistor Q2. With a HIGH signal on the base of transistor Q2 the voltage at terminal C should not be allowed to raise till about one $V_{BE}$ above $V_{BB}$ in order that transistor Q2 will be OFF.

The advantages of employing a single translation transistor Q2 between the first ISL gate and the TTL circuit is readily apparent. The PNP transistor Q2 may be incorporated in the same isolated island with the ISL transistor Q1, thereby conserving space. Furthermore, the PNP translation transistor Q2 replaces two additional ISL gates thereby further reducing space and also shortening the time delay.

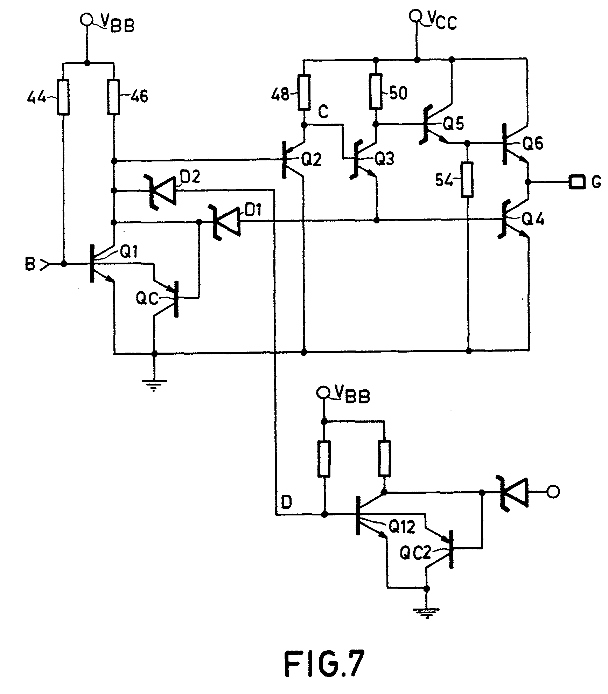

A further improvement may be effected by utilizing one of the Schottky diodes of the ISL circuit to perform a pulldown function for the output transistor Q4 of the TTL circuit. This improvement is illustrated in Figure 7, wherein the Schottky diode D3 and resistor 52 are eliminated from the base circuit of output transistor Q4. Instead, one of the Schottky diodes, such as D1, present in the collector region of the ISL transistor Q1, has its anode connected directly to the base of output transistor Q4 in common with the emitter of transistor Q3. As a result, when a HIGH logic signal is applied to input terminal B turning transistor Q1 ON, diode D1 is also turned ON, placing the base of output transistor Q4 at a voltage above ground equal only to the internal voltage drop of transistor Q1 plus the forward voltage drop of diode D1, both of which are very small. The low voltage applied to the base of transistor Q4 holds it OFF. In this active pull down the low internal voltage drop of an ISL clamped transistor as compared to a Schottky clamp transistor is a major advantage.

The active pull down formed by transistor Q1 and diode D1 holds the base of the output transistor Q4 OFF through the low forward resistance of Schottky diode D1. A true collector-base breakdown is seen at point G, instead of a collector emitter breakdown when a transistor or resistor is used as a pull down. Another advantage is that when transistor Q4 is turned ON diode D1 is reversed biased and the entire emitter current of transistor Q3 goes to transistor Q4 instead of splitting between transistor Q4 and diode D3, as it would in the circuit of Figure 6. The active pull down afforded by diode D1 and transistor Q1 provides yet another advantage in assuring that transistor Q4 turns off before transistor Q5 and Q6 turn on, thereby eliminating current spikes that would occur if transistors Q5 and Q6 and Q4 were on at the same time.

In the examples described the conductivity types may be interchanged. Such modified examples may be operated with similar voltages but of opposite polarity.

Although silicon is preferred, semiconductor materials other than silicon may be used also, for instance $A_{III}$—$B_V$ compounds. In the Schottky diodes other materials like PtSi or Al may be used. Moreover, other conventional isolation technologies may be used such as air-isolation, V-grooves or grooves filled with insulating and/or semiconductive material.

## Claims

1. An integrated logic circuit having a signal input formed by a control electrode of a transistor and having one or more outputs each coupled via a diode to a first main electrode of the transistor, the signal input comprising current supply means, the integrated circuit comprising a semiconductor body having a major surface and plural surface regions of a first conductivity type adjoining said major surface, said plural surface regions being situated on a common substrate region of a second conductivity type. opposite to the first conductivity type, each of the said surface regions being surrounded at the major surface by an isolation zone by means of which the surface regions are isolated electrically from each other.at least during operation, a first of said surface regions of the first conductivity type serving as the first main electrode of the transistor, said control electrode of the transistor being a surface zone of the second conductivity type situated in said first surface region and a second main electrode of the transistor adjoining the major surface and being separated from the control electrode by a rectifying junction, the first surface region at the major surface adjoining one or more conductor tracks each forming with the first main electrode a rectifying junction which serves as the said diode and in which in the first surface region and spaced from the said surface zone of the second conductivity type, a further surface zone of the second conductivity type is present, characterized in that said further surface zone serves as an extra signal output of the logic circuit and forms the emitter of a further transistor, the base and the collector of said further transistor being formed by the first surface region and the common substrate region, respectively.

2. An integrated logic circuit as claimed in Claim. 1, characterized in that said diode comprises a Schottky barrier junction.

3. An integrated logic circuit as claimed in Claim 1 or Claim 2, characterized in that the output of said further transistor is coupled to the base of an input transistor of an inverter circuit which further comprises an output transistor across which an output signal of the inverter circuit may be taken.

4. An integrated logic circuit as claimed in Claims 2 and 3, characterized in that one of said one or more outputs is coupled to the base of said output transistor of the inverter circuit.

5. An integrated logic circuit as claimed in Claim 3, characterized in that the input and the output transistor of the inverter circuit have a Schottky barrier junction between their base and collector connections.

6. An integrated logic circuit as claimed in Claim 3, 4 or 5, characterized in that the inverter circuit is operated at TTL supply and signal levels.

7. An integrated circuit as claimed in any of the preceding Claims, characterized in that at least one of said one or more outputs is coupled to the base input of the transistor of a similar logic circuit.

8. An integrated logic circuit as claimed in any of Claims 1 to 7, characterized in that said transistor of said integrated logic circuit is clamped by at least a vertical complementary transistor part sharing common regions with said transistor.

9. An integrated logic circuit as claimed in Claim 8, characterized in that said transistor is clamped by a lateral complementary transistor part and a vertical complementary transistor part, both of said complementary transistor parts sharing common regions with said transistor.

10. An integrated logic circuit as claimed in one or more of the preceding claims, characterized in that said first of said surface regions of the first conductivity type is separate portion of an epitaxial layer of the first conductivity and comprises a more highly doped region of the first conductivity type situated between said control electrode surface zone of the second conductivity type and said further surface zone of the second conductivity type, a buried layer of the first conductivity type being present at and in the vicinity of the interface between said epitaxial layer portion and said common substrate region, said buried layer extending at one end beneath the lateral extent of said second main electrode of said transistor but stopping short of one lateral extremity of said control electrode surface zone and extending beneath said more highly doped region but stopping short of said further surface zone of the second conductivity type.

11. An integrated logic circuit as claimed in Claim 10, characterized in that said separate epitaxial layer portion is laterally surrounded by an isolation wall extending from said major surface to said common substrate region.

12. An integrated logic circuit as claimed in Claim 11, characterized in that said isolation wall is made of semiconductive material of the second conductivity type.

13. An integrated logic circuit as claimed in Claim 11, characterized in that said isolation wall comprises dielectric material.

14. An integrated logic circuit as claimed in Claim 12, characterized in that a peripheral region of the second conductivity type is present which surrounds said control electrode surface zone on at least three sides thereof remote from said more highly doped region of the first conductivity type, said peripheral region being contiguous with a surface portion of said isolation wall.

15. An integrated logic circuit as claimed in Claim 12 or Claim 14, characterized in that said further surface zone is surrounded on at least three sides thereof remote from said more highly doped region of the first conductivity type by a peripheral region of the second conductivity type which is contiguous with a surface portion of said isolation wall.

16. An integrated logic circuit as claimed in one or more of the preceding claims, characterized in that said first main electrode of the transistor is connected to a first supply connection through a resistor and that the emitter of said further transistor is coupled to a second supply connection, clamping means being present for limiting the operating voltages at the emitter of the further transistor to be smaller than the sum of a forward pn-junction voltage and the supply voltage to be applied to said first supply connection.

17. An integrated logic circuit as claimed in Claims 3 and 16, characterized in that the series connection of the emitter-base diodes of the input and the output transistor of the inverter circuit is connected in parallel to the emitter-collector current path of the further transistor.

18. An integrated logic circuit as claimed in Claim 16 or Claim 17, characterized in that the first supply connection is to be connected to a supply source providing a supply voltage of about 1,5 Volt and that the second supply connection is to be connected to a supply source providing a supply voltage of about 5 Volts.

**Patentansprüche**

1. Logische integrierte Schaltung mit einem durch eine Steuerelektrode eines Transistors gebildeten Signaleingang und mit einem oder mehreren, je über eine Diode mit einer ersten Hauptelektrode des Transistors gekoppelten Ausgängen, wobei der Signaleingang Mittel zum zuführen von Strom aufweist, wobei die integrierte Schaltung einen Halbleiterkörper aufweist mit einer Hauptfläche und mehreren an die Hauptfläche grenzenden Oberflächengebieten eines ersten Leitungstyps, wobei diese Oberflächengebiete auf einem gemeinsamen Substratgebiet eines zweiten entgegengesetzten Leitungstyps vorgesehen sind, wobei jedes Oberflächengebiet an der Hauptfläche von einer Isolierzone umgeben ist, mit deren Hilfe die Oberflächengebiete wenigstens im Betrieb gegeneinander elektrisch isoliert sind, wobei ein erstes Gebiet der Oberflächengebiete vom ersten Leitungstyp als die erste Hauptelektrode des Transistors wirksam ist, wobei die Steuerelektrode des Transistors eine Oberflächenzone vom zweiten Leitungstyp in dem ersten Oberflächengebiet und wobei eine zweite Hauptelektrode des Transistors an die Hauptfläche grenzt und durch eine gleichrichtenden Übergang von der Steuerelektrode getrennt ist, wobei das erste Oberflächengebiet an der Hauptfläche an eine oder mehrere Leiterbahnen grenzt, die je mit der ersten Hauptelektrode einen Gleichrichterübergang bilden, der als die genannte Diode wirksam ist und in dem in dem ersten Oberflächengebiet und in einem Abstand von der Oberflächenzone vom zweiten Leitungstyp eine weitere Oberflächenzone vom zweiten Leitungstyp vorgesehen ist, dadurch gekennzeichnet, dass die weitere Oberflächenzone als extra Signalausgang der logischen Schaltung wirksam ist und den Emitter eines weiteren Transistors bildet, dessen Basis und Kollektor durch das erste Oberflächengebiet bzw. das gemeinsame Substratgebiet gebildet werden.

2. Logische integrierte Schaltung nach Anspruch 1, dadurch gekennzeichnet, dass die genannte Diode einen Schottky-Sperrschicht-übergang bildet.

3. Logische integrierte Schltung nach Anspruch 1 oder 2, dadurch gekennzeichnet, dass der Ausgang des weiteren Transistors mit der Basis eines Eingangstransistors eines Inverters gekoppelt ist, der weiterhin einen Ausgangstransistor aufweist, dem ein Ausgangssignal des Inverters entnommen werden kann.

4. Logische integrierte Schaltung nach Anspruch 2 oder 3, dadurch gekennzeichnet, dass einer der genannten Ausgänge mit de Basis des Ausgangstransistors des Inverters gekoppelt ist.

5. Logische integrierte Schaltung nach Anspruch 3, dadurch gekennzeichnet, dass der Eingangs- und der Ausgangstransistor des Inverters zwischen den Basis- und Kollektoranschlüssen einen Schottky-Sperrschicht-Übergang aufweisen.

6. Logische integrierte Schaltung nach Anspruch 3, 4 oder 5, dadurch gekennzeichnet, dass der Inverter auf TTL-Speise- und Signalpegeln betrieben wird.

7. Logische integrierte Schaltung nach einem der vorstehenden Ansprüche, dadurch gekennzeichnet, dass wenigstens einer der genannten Ausgangänge mit dem Basiseingang des Transistors einer ähnlichen logischen Schaltung gekoppelt ist.

8. Logische integrierte Schaltung nach einem der Ansprüche 1 bis 7, dadurch gekennzeichnet, dass der genannte Transistor der genannten logischen integrierten Schaltung mittels wenigstens eines vertikal-komplementären Transistorteils geklemmt ist, der mit dem genannten Transistor geinsame Gebiete benutzt.

9. Logische integrierte Schaltung nach Anspruch 8, dadurch gekennzeichnet, dass der genannte Transistor mittels eines lateralkomplementären Transistorteils und eines vertikal-komplementären Transistorteils geklemmt ist, wobei die beiden komplementären Transistorteile mit dem genannten Transistor gemeinsame Gebiete benutzen.

10. Logische integrierte Schaltung nach einem der vorstehenden Ansprüche, dadurch gekennzeichnet, dass das erste der Oberflächengebiete vom ersten Leitungstyp von einen abgetrennten Teil einer Epitaxialschicht vom ersten Leitungstyp gebildet wird und ein zwischen der Steuerelektrodenflächenzone vom zweiten Leitungstyp und der weiteren Oberflächenzone vom zweiten Leitungstyp liegendes, höherdotiertes Gebiet vom ersten Leitungstyp aufweist, wobei eine begrabene Schicht vom ersten Leitungstyp an dem und in der Nähe des Interfaces zwischen dem Epitaxialschichtteil und dem gemeinsamen Substratgebiet vorhanden ist, wobei diese begrabene Schicht sich an einem Ende unter der lateralen Ausdehnung der genannten zweiten Hauptelektrode des genannten Transistors erstreckt, aber in der unmittelbaren Nähe eines lateralen Ausläufers der genannten Steuerelektrodenoberflächenzone endet und sich unter dem genannten höher dotierten Gebiet erstreckt aber in der unmittelbaren Nähe der genannten weiteren Oberflächenzone vom zweiten Leitungstyp endet.

11. Logische integrierte Schaltung nach Anspruch 10 dadurch gekennzeichnet, dass der genannte abgetrennte Epitaxial schichtteil von einer Isolierwand lateral umgeben ist, die sich von der genannten Hauptfläche bis an das genannte gemeinsame Substratgebiet erstreckt.

12. Logische integrierte Schaltung nach Anspruch 11, dadurch gekennzeichnet, dass die Isolierwand aus Halbleitermaterial vom zweiten Leitungstyp besteht.

13. Logische integrierte Schaltung nach Anspruch 11, dadurch gekennzeichnet, dass die Isolierwand dielektrisches Material aufweist.

14. Logische integrierte Schaltung nach Anspruch 12, dadurch gekennzeichnet, dass ein Peripheriegebiet vom zweiten Leitungstyp vorhanden ist, das die Steuerelektrodenoberflächenzone wenigstens an drei Seiten weg von dem höher dotierten Gebiet vom ersten Leitungstyp umgibt, wobei dieses Peripheriegebiet an einen Oberflächenteil der genannten Isolierwand grenzt.

15. Logische integrierte Schaltung nach Anspruch 12 oder 14, dadurch gekennzeichnet, dass die weitere Oberflächenzone an wenigstens drei Seiten weg von dem höher dotierten Gebiet vom ersten Leitungstyp von einem Peripheriegebiet vom zweiten Leitungstyp umgeben ist, wobei dieses Peripheriegebiet an einen Oberflächenteil der genannten Isolierwand grenzt.

16. Logische integrierte Schaltung nach einem oder mehreren der vorstehenden Ansprüche, dadurch gekennzeichnet, dass die erste Hauptelektrode des Transistors über einen Widerstand mit einem ersten Speiseanschluss verbunden ist und dass der Emitter des weiteren Transistors mit einem zweiten Speiseanschluss gekoppelt ist, wobei Klemmmittel vorhanden sind zum Beschränken der Betriebsspannungen an dem Emitter des weiteren Transistors, damit diese kleiner sind als die Summe einer Vorwärts-PN-Übergangsspannung und der dem genannten Speiseanschluss zuzuführenden Speisespannung.

17. Logische integrierte Schaltung nach Anspruch 3 und 16, dadurch gekennzeichnet, dass der Reihenanschluss der Emitter-Basis-Dioden des Eingangs- und des Ausgangstransistors des Inverters parallel mit der Emitter-Kollektor-Stromstrecke des weiteren Transistors verbunden ist.

18. Logische intergrierte Schaltung nach Anspruch 16 oder 17, dadurch gekennzeichnet, dass der erste Speiseanschluss dazu bestimmt ist mit einer Speisequelle verbunden zu werden, die eine Speisespannung von etwa 1,5 Volt liefert und dass der zweite Speiseanschluss dazu bestimmt ist mit einer Speisequelle verbunden zu werden, die eine Speisespannung von etwa 5 Volt liefert.

## Revendications

1. Circuit logique intégré muni d'une entrée de signal formée par une électrode de commande d'un transistor et présentant une ou plusieurs sorties couplées chacune par l'intermédiaire d'une diode à une première électrode principale du transistor, l'entrée de signal comportant des moyens d'alimentation de courant, le circuit intégré comportant un corps semiconducteur présentant une surface principale et plusieurs régions superficielles d'un premier type de conductivité confinant à ladite surface principale, lesdites régions superficielles étant situées sur une région de substrat commune d'un second type de conductivité opposé au premier type de conductivité, chacune desdites régions superficielles étant entourée à la surface principale d'une zone d'isolation à l'aide de laquelle les régions superficielles sont isolées électriquement les unes des autres au moins pendant le fonctionnement, une première desdites régions superficielles du premier type de conductivité servant de première électrode principale du transistor, ladite électrode de commande du transistor étant une zone superficielle du second type de conductivité située dans ladite première région superficielle et une deuxième électrode principale du transistor confinant à la surface principale et étant séparée de l'électrode de commande par une jonction redresseuse, la première région superficielle à la surface principale confinant à une ou plusieurs pistes conductrices formant chacune avec la première électrode principale une jonction redresseuse qui fait office de ladite diode et dans laquelle est présente une autre zone superficielle de second type de conductivité dans la première région superficielle et d'une façon espacée de ladite zone superficielle du second type de conductivité, caractérisé en ce que ladite autre zone superficielle fait office de sortie de signal additionnelle de circuit logique et constitue l'émetteur d'un autre transistor, la base et le collecteur dudit autre transistor étant formés par la première région superficielle et la région de substrat commune respectivement.

2. Circuit logique intégré selon la revendication 1, caractérisé en ce que ladite diode comprend une jonction de barrière Schottky.

3. Circuit logique intégré selon la revendication 1 ou la revendication 2, caractérisé en ce que la sortie dudit autre transistor est couplée à la base d'un transistor d'entrée d'un circuit inverseur qui comporte en outre au autre transistor de sortie sur lequel peut être prélevé un signal de sortie du circuit inverseur.

4. Circuit logique intégré selon la revendication 2 et 3, caractérisé en ce que l'une desdites une ou plusieurs sorties est couplée à la base dudit transistor de sortie du circuit inverseur.

5. Circuit logique intégré selon la revendication 3, caractérisé en ce que le transistor d'entrée et de sortie du circuit inverseur présentent une jonction de barrière Schottky entre leurs connexions de base et de collecteur.

6. Circuit logique intégré selon la revendication 3, 4 ou 5, caractérisé en ce que le circuit inverseur fonctionne à des niveaux d'alimentation et de signal LTT.

7. Circuit intégré selon l'une des revendications précédentes, caractérisé en ce qu'au moins l'une desdites une ou plusieurs sorties est couplée à l'entrée de base du transistor d'un circuit logique similaire.

8. Circuit logique intégré selon l'une des revendications 1 à 7, caractérisé en ce que ledit transistor dudit circuit logique intégré est calé par au moins une partie de transistor complémentaire verticale présentant des régions communes avec ledit transistor.

9. Circuit logique intégré selon la revendication 8, caractérisé en ce que ledit transistor est calé par une partie de transistor complémentaire latérale et une partie de transistor complémentaire verticale, les deux parties de transistor complémentaires présentant des régions communes avec ledit transistor.

10. Circuit logique intégré selon l'une ou plusieurs des revendications précédentes, caractérisé en ce que ladite première desdites régions superficielles du premier type de conductivité est une partie séparée d'une couche épitaxiale du premier type de conductivité et comporte une région plus dopée du premier type de conductivité située entre ladite zone superficielle de l'électrode de commande du second type de conductivité et ladite autre zone superficielle du second type de conductivité, une couche enterrée du premier type de conductivité étant présente à et à proximité de l'interface entre ladite partie de couche épitaxiale et ladite région de substrat commune, ladite couche enterrée s'étendant à une extrémité au-dessous de l'étendue latérale de ladite deuxième électrode principale dudit transistor tout en s'arrêtant net à une extrémité latérale de ladite zone superficielle de l'électrode de commande et s'étendant au-dessous de ladite région plus dopée tout en s'arrêtant net à ladite autre zone superficielle du second type de conductivité.

11. Circuit logique intégré selon la revendication 10, caractérisé en ce que ladite partie de couche épitaxiale séparée est latéralement entourée d'une paroi d'isolation s'étendant à partir de ladite surface principale vers ladite région de substrat commune.

12. Circuit logique intégré selon la revendication 11, caractérisé en ce que ladite paroi d'isolation est réalisée en matériau semiconducteur du second type de conductivité.

13. Circuit logique intégré selon la revendication 11, caractérisé en ce que ladite paroi d'isolation contient du matériau diélectrique.

14. Circuit logique intégré selon la revendication 12, caractérisé en ce qu'une région périphérique du second type de conductivité est présente et entoure ladite zone superficielle de l'électrode de commande d'au moins trois côtés de cette dernière non situés vis-à-vis de ladite région plus dopée du premier type de conductivité, ladite région périphérique étant contiguë à une partie superficielle de ladite paroi d'isolation.

15. Circuit logique intégré selon la revendication 12 ou la revendication 14, caractérisé en ce que ladite autre zone superficielle est entourée d'au moins trois côtés de cette dernière opposés à ladite autre région plus dopée du premier type de conductivité par une région périphérique du second type de conductivité qui est contiguë à une partie superficielle de ladite paroi d'isolation.

16. Circuit logique intégré selon l'une ou plusieurs des revendications précédentes, caractérisé en ce que ladite première électrode principale du transistor est connectée à une première connexion d'alimentation par l'intermédiaire d'une résistance et en ce que l'émetteur dudit autre transistor est couplé à une deuxième connexion d'alimentation, des moyens de calage étant présents pour limiter les tensions de fonctionnement à l'émetteur de l'autre transistor de façon qu'elles soient inférieures à la somme d'une tension de jonction pn en sens direct et la tension d'alimentation à appliquer à ladite première connexion d'alimentation.

17. Circuit logique intégré selon les revendications 3 et 16, caractérisé en ce que le montage en série des diodes émetteur-base du transistor d'entrée et de sortie du circuit inverseur est monté en parallèle au trajet de courant émitter-collecteur de l'autre transistor.

18. Circuit logique intégré selon la revendication 16 ou 17, caractérisé en ce que la première connexion d'alimentation doit être connectée à une source d'alimentation fournissant une tension d'alimentation d'environ 1,5 volt et que la deuxième connexion d'alimentation doit être connectée à une source d'alimentation fournissant une tension d'alimentation d'environ 5 volts.

FIG.1

FIG.2

FIG.3

FIG.4

FIG.5

2

FIG.6

FIG.7